# EUROPÄISCHE PATENTSCHRIFT

(11) **EP 2 402 718 B1**
(45) Veröffentlichungstag und Bekanntmachung des Hinweises auf die Patenterteilung: **09.05.2012**
(21) Anmeldenummer: 10006459.1
(22) Anmeldetag: 22.06.2010
(51) Int. Cl.: G01D 4/00

(54) **Vorrichtung und Verfahren zum Messen von elektrischer Arbeit**
Method and device for measuring electrical work
Dispositif et procédé destinés à la mesure de travail électrique

(43) Veröffentlichungstag der Anmeldung: 04.01.2012
(73) Patentinhaber: Siegel, Holger, 42285 Wuppertal (DE)
(72) Erfinder: Siegel, Holger, 42285 Wuppertal (DE)
(74) Vertreter: Patentanwälte Buse, Mentzel, Ludewig

(56) Entgegenhaltungen:
- WO-A1-2006/017671
- WO-A1-2008/086213
- GB-A- 2 442 760
- US-A1- 2008 150 750
- US-A1- 2010 026 517

## Beschreibung

Die Erfindung betrifft eine Vorrichtung sowie ein Verfahren zum Messen elektrischer Arbeit. Eine solche Funktion wird in den meisten Haushalten über einen Stromzähler realisiert, der von einem entsprechenden Stromversorgungsunternehmen im Haushalt installiert und regelmäßig abgelesen wird.

Das Ablesen erfolgt manuell vor Ort und aufgrund der abgelesenen Daten wird dann der verbrauchte Strom dem Haushalt in Rechnung gestellt.

Viele Stromversorger bieten zudem vergünstigte Tarife an, die allerdings mit einem üblichen Stromzähler oftmals nicht kontrollierbar sind. Hierzu zählen beispielsweise Minutenstromtarife, in denen minütlich je nach Lastanforderung vom Versorgungsunternehmen ein verbilligter Tarif minütlich freigeschaltet wird sowie Nachstromtarife, etc.

Damit der Stromversorger hierzu eine detaillierte Rechnung erstellen kann, benötigt man intelligente Stromzähler, welche den geraden aktuell benutzten Tarif sowie den dazu verbrauchten Strom zählen. Auf dem Markt sind solche intelligente Stromzähler als "Smartmeter" bekannt.

Bei diesen herkömmlichen "Smartmetern" wird über eine Schnittstelle dem "Smartmeter" der aktuell verfügbare Tarif des Versorgungsunternehmens übermittelt. Je nach Konfiguration schaltet dann das "Smartmeter" einen oder mehrere Ausgänge zum Verbraucher für den aktuell anliegenden Stromtarif ein oder aus.

Aufgrund der oben genannten Funktionsweise solcher herkömmlicher "Smartmeter" ergeben sich einige Nachteile. Das Schalten einiger Endgeräte ist nicht immer unkompliziert. Manche Geräte sind für einen Betrieb ohne Unterbrechung ausgelegt, so dass ein häufiges Ein- und Ausschalten zu Störung oder Fehlfunktion führen kann. Es lässt sich also nur unzureichend eine Versorgung mit einem bestimmten Strom aus einem bestimmten Tarif realisieren.

Da die herkömmlichen Stromzähler sowie die "Smartmeter" vom Stromversorger im Haushalt installiert werden und über die Informationen des aktuell anliegenden Stromtarifes die Verbraucher ein- und ausgeschaltet werden, ergibt sich die Frage, ob der Stromversorger überhaupt das Recht hat, in einem Haushalt Geräte zu steuern. Da der Endkunde nicht der eigentliche Eigentümer des "Smartmeters" ist, ist somit ungeklärt, wer die Schalthoheit für die Endgeräte des Endverbrauchers besitzt.

Bei einer Möglichkeit, die Endgeräte direkt durch den Stromversorger zu steuern, ergibt sich weiterhin die Schwierigkeit der technischen Umsetzung, da sicherlich die Steuerung jedes einzelnen Endgeräts eines Endkunden einen sehr hohen Steuerungsaufwand bedarf, welcher vonseiten des Stromversorgers übernommen werden müsste. Zudem stellt sich die Frage der sicheren Kommunikation zwischen dem Stromversorger und dem "Smartmeter". Ein nicht unerhebliches Risiko besteht darin, dass ein Unberechtigter Zugang zur Kommunikation mit dem "Smartmeter" erhält und somit Endgeräte ein- und/oder ausschalten kann.

Die WO 2006/017671 zeigt bereits ein Smartmetersystem, welches allerdings die oben genannten Nachteile aufweist. Bei dem in dieser Druckschrift beschriebenen System werden die angeschlossenen Verbraucher über das Internet durch den Stromversorger geschaltet. Damit ergibt sich die Schwierigkeit der sicheren Kommunikation und das Risiko, dass ein Unberechtigter Zugang zur Kommunikation und dem Smartmeter erhält. Ebenso kann der Benutzer der Endgeräte nicht bei schwierigen Geräten selbst bestimmen, ob ein Gerät durch Tarifänderung ein- und ausgeschaltet werden soll oder nicht. Ebenso ergibt sich bei dieser Lösung die Frage, ob das Versorgungsunternehmen überhaupt die Schalthoheit über die Endverbraucher besitzen darf oder nicht.

Die vorliegende Erfindung zeigt ein Verfahren unter Verwendung einer Vorrichtung, die die oben genannten Nachteile überwindet.

Der vorliegenden Erfindung liegt also die Aufgabe zugrunde, ein intelligentes Verfahren mittels einer Vorrichtung zum Messen von elektrischer Arbeit zu realisieren, bei welchem für jedes angeschlossene Endgeräte einzeln definiert werden kann, wann ein- oder ausgeschaltet wird, bei dem die Schalthoheit letztendlich beim Endkunden liegt und bei dem keine Sicherheitsrisiken aufgrund von Schaltbefehlen durch den Stromversorger existieren. Trotzdem soll durch das Verfahren mittels der Vorrichtung eine möglichst genaue Abrechnung verschiedener Tarife vom Stromversorger ermöglicht werden.

Diese Aufgaben werden durch das Verfahren des Anspruchs 8 in Verbindung mit der Vorrichtung aus Anspruch 1 gelöst. Die Vorrichtung wird dabei anders als bei den herkömmlichen "Smartmetern" vom Endkunden selber installiert, da die Vorrichtung mit einem Stecker zum Anschließen der Vorrichtung an eine Steckdose vorgesehen ist. Hierzu sind für verschiedene Steckdosenarten verschiedene Ausführungsformen vorgesehen, beispielsweise eine Ausführungsform für eine herkömmliche Wechselstromsteckdose sowie eine Ausführungsform für eine Drehstromsteckdose.

An die Vorrichtung wird mittels mindestens einem schaltbaren Ausgang mindestens ein elektrischer Verbraucher angeschlossen, dessen elektrischer Stromverbrauch über die Vorrichtung gezählt werden soll.

Die Vorrichtung selbst verfügt über mindestens eine Verbindungsmöglichkeit mit dem Internet, welche dazu verwendet wird, um vom Stromversorger Daten zum aktuell verwendbaren Tarif übermittelt zu bekommen. Die möglichen Tarife können vertraglich zwischen dem Endkunden und dem Stromversorger geregelt werden.

Ebenfalls in der Vorrichtung vorgesehen ist eine Uhr, welche elektronisch von der Vorrichtung zur Ermittlung der aktuellen Uhrzeit genutzt wird. Diese Uhr kann über die Verbindungsmöglichkeiten mit dem Internet manuell gestellt werden oder über ein Zeitsignal des Internets automatisch gestellt werden. Über die Kombination des Stromverbrauchs des angeschlossen Verbrauchers und der Zeit, die aus der Uhr ausgelesen werden kann, bestimmt sich die elektrische Arbeit des elektrischen Verbrauchers.

Weiterhin ist ein elektronischer Speicher in der Vorrichtung vorgesehen, in welchem elektronisch Daten gespeichert werden können, insbesondere sind hierbei die Daten aus dem Internet, beispielsweise Tarifdaten, Uhrzeiten, die vorgenommenen Schaltvorgänge des Verbrauchers sowie dessen Stromaufnahme gesamt und im jeweiligen Tarif zu speichern. Die intelligente Steuerung der oben genannten elektronischen Elemente übernimmt hierbei ein Mikrocontroller, welcher in die Vorrichtung eingebracht ist oder auf einer "Smartcard" vorgesehen ist, welche in die Vorrichtung einbringbar ist.

Die in der Vorrichtung gespeicherten Daten können über die Internetverbindung übertragen und ausgewertet werden. In einer besonderen Ausführungsform ist es ebenfalls möglich, über eine Anzeige an der Vorrichtung selber die gespeicherten Werte abzulesen und auszuwerten sowie die Daten eines "elektrischen" Hauptzählers zu erfassen und zu übertragen.

In einer weiteren besonderen Ausführungsform ist mindestens ein Schalter oder ein Taster vorgesehen, über welchen das Schaltverhalten des schaltbaren Ausgangs zum Verbraucher eingestellt werden kann. Dieser Schalter oder Taster dient dazu, dass der Endkunde an der Vorrichtung selber festlegen kann, ob ausschließlich zu einem gewählten Tarif der Verbraucher eingeschaltet werden soll, ob er dauerhaft eingeschaltet wird oder gar nicht eingeschaltet wird. Somit hat der Endkunde selber letztlich die Schalthoheit über seine Geräte. Er kann jedoch über den Schalter oder Taster das Schalten des Verbrauchers von einem jeweils gerade verfügbaren Tarif abhängig machen.

Für die Verbindungsmöglichkeit der Vorrichtung an das Internet kann je nach Ausführungsform ein kabelgebundener Netzwerkanschluss dienen und/oder ein an der Vorrichtung vorgesehener WLAN-Anschluss und/oder Mobilfunkanschluss und/oder ein sogenannter Powerline-Anschluss, bei welchem die Daten auf den Spannungsverlauf des normalen Stromnetzes aufmoduliert werden. Durch die verschiedenen Anschlussmöglichkeiten der Vorrichtung an das Internet soll ein reibungsloser und unkomplizierter Anschluss gewährleistet werden.

Bei dem Verfahren zum Messen der elektrischen Arbeit und der tarifgenauen Abrechnung des verbrauchten Stromes wird also vom Endkunden selber die oben genannte Vorrichtung an eine Streckdose angeschlossen und mindestens ein elektrischer Verbraucher an die Vorrichtung angeschlossen. Die Vorrichtung selber weiß zu jeder Zeit, welcher aktuelle Tarif vom Stromversorger verfügbar ist. Diese Informationen können auf zweierlei Arten der Vorrichtung zur Verfügung gestellt werden:

Zum einen kann über die Verbindungsmöglichkeit mit dem Internet der aktuelle Tarif vom Versorgungsunternehmen abgerufen werden, zum anderen kann jedoch auch eine oder mehrere Tarifzeiten fest in der Vorrichtung hinterlegt werden. Über die in der Vorrichtung eingebaute Uhr weiß dann die Vorrichtung, zu welcher Zeit welcher Tarif zur Verfügung steht. Die gespeicherten Tarifzeiten ermöglichen der Vorrichtung ein tarifgenaues Schalten des Verbrauchers, auch wenn die aktuellen Tarifinformationen über die Internetverbindung gerade nicht zur Verfügung stehen. Die eingespeicherten Tarifzeiten können über die Verbindungsmöglichkeit mit dem Internet, insbesondere vom Stromversorger, in die Vorrichtung eingespeichert werden.

Je nach gerade zur Verfügung stehendem Tarif wird dann der Verbraucher ein- bzw. ausgeschaltet. In einer besonderen Ausführungsform steht ein Taster oder Schalter zur Verfügung, mit welchem der Endkunde festlegen kann, ob der Verbraucher, welcher an die Vorrichtung angeschlossen ist, ausschließlich bei einem bestimmten zur Verfügung stehenden Tarif eingeschaltet werden soll, dauerhaft eingeschaltet ist oder ausgeschaltet sein soll oder für einen bestimmten Zeitraum eingeschaltet bleiben soll.

Über den in der Vorrichtung vorgesehenen elektronischen Speicher werden die der Vorrichtung zur Verfügung stehenden Informationen abgelegt und archiviert, insbesondere die Tarifinformationen, die Uhrzeiten, die Stromaufnahme der Verbraucher und die Schaltvorgänge.

Bei einer Abrechnung durch den Stromversorger kann nun über die im Speicher abgelegten Informationen eine zeit- und tarifgenaue Abrechnung für den oder die an die Vorrichtung angeschlossenen Verbraucher erstellt werden. Da die eigentliche Abrechnung weiterhin über den weiterhin im Haushalt vorhandenen herkömmlichen Stromzähler geschieht, werden dem Endkunden aufgrund der in der Vorrichtung gespeicherten Informationen für die Zeiten zu dem der an der Vorrichtung angeschlossenen Verbraucher mit einem verbilligten Tarif betrieben wurde, Gutschriften erstellt. Diese Gutschriften können dann nach Vereinbarung mit dem Stromversorger ausgezahlt oder mit der nächsten Abrechung verrechnet werden.

Da die Schalthoheit, wie oben beschrieben, letztendlich dem Endkunden zuzuschreiben ist, kann der Endkunde selber bestimmen, wie und unter welchen Umständen ein Verbraucher geschaltet werden kann oder/oder soll. Die Anzahl der eingesetzten erfindungsgemäßen Vorrichtungen in einem Haushalt sind ebenfalls nicht begrenzt, da diese nicht jederzeit vom Versorgungsunternehmen angesteuert werden müssen. Die Absicherung der Verbindung zum Internet ist ebenfalls für das Schalten der Verbraucher zweitrangig, da keinerlei Schaltbefehle der Vorrichtung erteilt werden können. Somit können keine Unberechtigten die angeschlossenen Verbraucher schalten.

In einer weiteren bevorzugten Ausführungsform ist an der Vorrichtung eine zusätzliche Steuermöglichkeit vorgesehen. Diese Steuermöglichkeit soll verhindern, dass mehrere erfindungsgemäße Vorrichtungen hintereinandergeschaltet werden und somit vom Stromversorger mehrfache Gutschriften für den gleichen Verbraucher erstellt werden.

Eine mögliche Steuermöglichkeit für die erfindungsgemäße Vorrichtung ist ein zusätzliches auf die Netzspannung aufgebrachtes Signal, welches den Strom eines Verbrauchers "markiert". Hierbei besitzt eine erfindungsgemäße Vorrichtung einen Empfänger zum Auswerten der Markierung, einen Sender zum Aufbringen der Markierung und optional ein Netzfilter, um die Netzspannung nicht zu stören, da auf der Netzspannung bereits andere Signale aufmoduliert sein können. Die Markierung des Stroms für einen Verbraucher bestimmt sich aus einer Leistungsmessung, welche die erfindungsgemäße Vorrichtung vornimmt. Sollte eine zusätzliche zweite erfindungsgemäße Vorrichtung in Reihe zu einer ersten erfindungsgemäßen Vorrichtung geschaltet sein, wird über den Empfänger die Markierung eines Verbrauchers gelesen. Sollte hierbei festgestellt werden, dass der Strom des Verbrauchers bereits erfasst wurde, da der Strom "markiert" ist, wird keine weitere Erfassung des jeweiligen Verbrauchers vorgenommen bzw. der Ausgang zum jeweiligen Verbraucher nicht ein- oder ausgeschaltet.

Als Alternative zur oben genannten Markierung eines Verbraucherstroms kann die Steuermöglichkeit auch über eine kabelgebundene Steuerleitung und/oder über ein Funksignal realisiert werden.

Alternativ zu der oben genannten Möglichkeit der Markierung des Stroms ist in einer weiteren bevorzugten Ausführungsform vorgesehen, dass bei jedem Schaltvorgang der Vorrichtung über die Zeit und den Stromverbrauch des jeweiligen Verbrauchers ein kurzzeitiges Lastprofil im elektronischen Speicher der Vorrichtung abgelegt wird. Bei der Abrechnung über den Stromversorger können dann die Schaltvorgänge, welche zu gleichen Zeiten geschehen, über die Lastprofile verglichen werden und bei gleichem Lastprofil nur einmal als Gutschrift abgerechnet werden.

Das oben genannte Verfahren bedingt, dass bei dem jeweiligen Stromversorger entsprechende Tarife, wie Minutenstrom oder Nachtstrom vom Endkunden beantragt werden und die erfindungsgemäßen Vorrichtungen beim Stromversorger angemeldet werden.

Bei der oben genannten Ausführungsform der erfindungsgemäßen Vorrichtung mit Taster oder Schalter kann an der Vorrichtung vom Endkunden eingestellt werden, ob ein bestimmter Tarif ausschließlich das Schalten des Endverbrauchers verursacht, der Tarif lediglich erfasst wird, der Verbraucher jedoch auch in der übrigen Zeit eingeschaltet bleibt, der Verbraucher grundsätzlich eingeschaltet ist oder der Verbraucher grundsätzlich ausgeschaltet ist. Ebenso kann eingestellt werden, dass zwar kein Schaltvorgang bei einer der oben genannten Bedingungen ausgeführt werden soll, jedoch an der erfindungsgemäßen Vorrichtung mindestens ein Warnsignal erscheinen soll. Dieses Warnsignal kann auf der eingangs genannten optionalen Anzeige angezeigt werden oder durch geeignete optische oder akustische Mittel.

Die Konfiguration der erfindungsgemäßen Vorrichtung sowie das Übermitteln der Daten kann über das Versorgungsunternehmen erfolgen, es kann jedoch auch von dem Endkunden selber erfolgen. Zu der Konfiguration gehört auch die Definition und Funktion der einzelnen Tarife für die verschiedenen Taster oder Schalterstellungen der oben genannten Ausführungsform mit Taster oder Schalter.

Das Auslesen der Daten durch den Endkunden oder durch den Stromversorger geschieht über die oben genannten Verbindungsmöglichkeiten oder auch über eine optional an der Vorrichtung vorgesehene Schnittstelle. Diese kann eine herkömmliche serielle Schnittstelle oder auch eine Schnittstelle zu einem beliegen BUS-System sein.

Die Steuerung der oben genannten Vorrichtung sowie die Auswertung der der Vorrichtung zur Verfügung stehenden Informationen werden über einen Mikrocontroller realisiert. Dieser Mikrocontroller wird extern der Vorrichtung zugeführt. Der Mikrocontroller ist auf einer Smart-Card integriert, welche in die Vorrichtung eingebracht werden kann. Die oben genannten Funktionen sowie das Verfahren dazu erfolgen dann nur, wenn die Smart-Card in die Vorrichtung eingebracht ist.

Weitere Vorteile der vorliegenden Erfindung ergeben sich aus den nachfolgenden Zeichnungen sowie der Beschreibung dazu. Es zeigen:
- Fig. 1: ein Blockschaltbild zur Einbringung der erfindungsgemäßen Vorrichtung in das Stromnetz,
- Fig. 2: ein Blockschaltbild einer Ausführungsform zweier erfindungsgemäßer Vorrichtungen, welche hintereinander an einem Verbraucher angeschlossen sind und durch Erstellung kurzer Lastprofile das doppelte Zählen des vom Verbraucher verbrauchten Stromes verhindern.
- Fig. 3: Ein Blockschaltbild einer erfindungsgemäßen Vorrichtung, welche durch eine zusätzliche Steuermöglichkeit den bereits gezählten Strom "markiert".

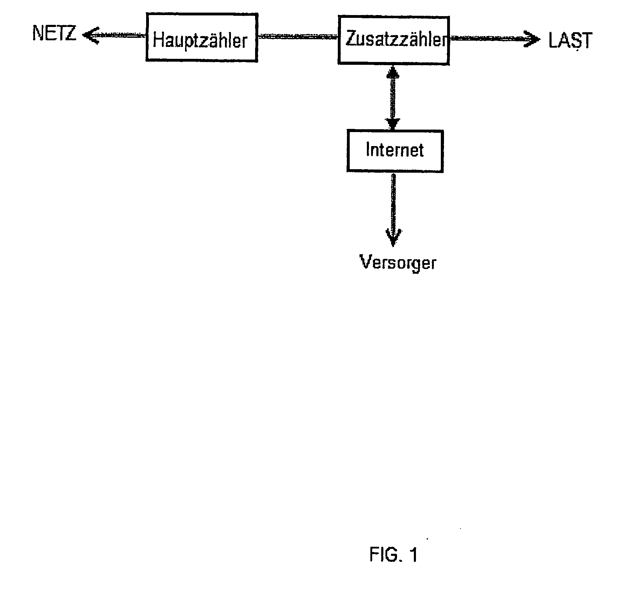

In der Fig. 1 ist die erfindungsgemäße Vorrichtung als Zusatzzähler zu dem handelsüblichen Stromzähler (in der Figur als Hauptzähler bezeichnet) zu sehen. Der Hauptzähler fungiert weiterhin als hauptsächlicher abrechnungsrelevanter Stromzähler, wobei die erfindungsgemäße Vorrichtung als Zusatzzähler hinter den Hauptzähler geschaltet ist. Der Zusatzzähler kann dabei an jeder beliebigen Stelle des Stromnetzes an eine Steckdose angeschlossen werden.

Der zu betreibende Verbraucher wird dann an den Zusatzzähler angeschlossen, wobei der Zusatzzähler somit zwischen der Steckdose und dem Verbraucher angeordnet ist. Somit fließt jeder Strom zu dem Verbraucher nicht nur, wie bisher üblich, über den Hauptzähler, sondern nun auch über die erfindungsgemäße Vorrichtung, nämlich dem Zusatzzähler. Über eine Anschlussmöglichkeit an das Internet besitzt die erfindungsgemäße Vorrichtung eine Verbindung zu dem Stromversorger, über welche die erfindungsgemäße Vorrichtung die aktuellen zur Verfügung stehenden Tarife vom Stromversorger abrufen kann.

Je nach zur Verfügung stehenden Stromtarif kann dann die erfindungsgemäße Vorrichtung den Verbraucher ein- oder ausschalten. Zusätzlich ist in einer bevorzugten Ausführungsform ein Schalter oder Taster vorgesehen, über welchen das Schaltverhalten der erfindungsgemäßen Vorrichtung einstellbar ist. Hierbei kann insbesondere gewählt werden, ob der Verbraucher dauerhaft nicht eingeschaltet ist, nur bei zur Verfügung stehenden bestimmten Tarifen eingeschaltet wird oder dauerhaft eingeschaltet wird.

Die erfindungsgemäße Vorrichtung (hier Zusatzzähler) speichert in dem zugehörigen elektronischen Speicher die oben beschriebenen Informationen, welche dann zum Abruf bereitstehen, sei es über die Verbindungsmöglichkeit zum Internet oder einer physikalisch am Zusatzzähler vorhanden Schnittstelle. In einem besonderen Ausführungsbeispiel ist auch eine Anzeige an der erfindungsgemäßen Vorrichtung vorgesehen, über welche die gespeicherten Informationen ebenfalls abrufbar sind.

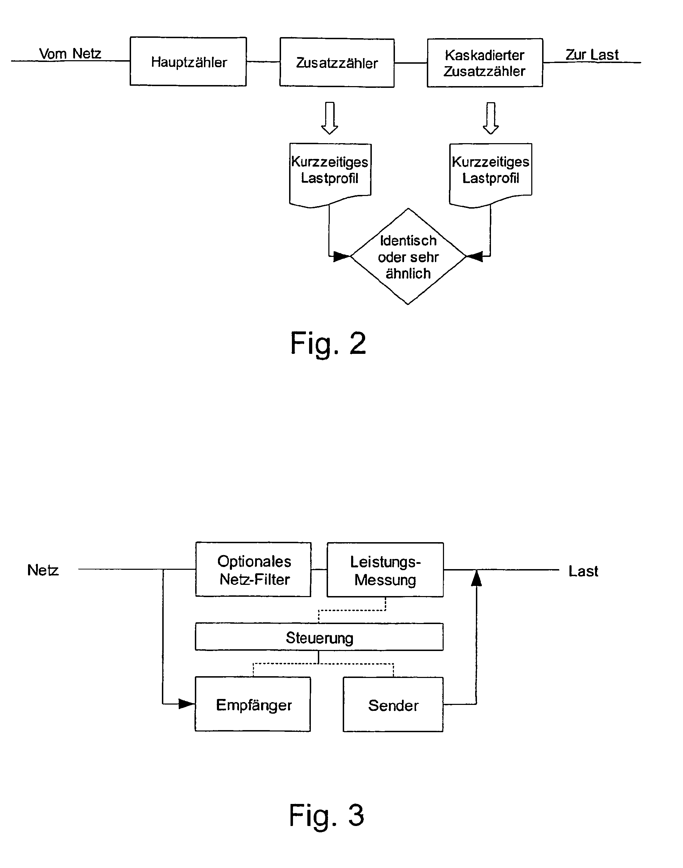

Fig. 2 zeigt die bereits oben beschriebene Sicherheitsfunktion zur Vermeidung von doppelter Stromzählung. Da es möglich ist, mehrere erfindungsgemäße Vorrichtungen als Zusatzzähler zwischen Hauptzähler und dem Verbraucher einzubringen, müssen Sicherheitsmaßnahmen ergriffen werden, damit der Strom zum Verbraucher nur einmal gezählt wird. Hierbei wird von jeder erfindungsgemäßen Vorrichtung bei Einschalten des nachgeschalteten Verbrauchers über die Zeit und dem Stromverbrauch ein kurzzeitiges Lastprofil erstellt und im elektronischen Speicher der erfindungsgemäßen Vorrichtung abgelegt. Bei der Abrechnung durch den Stromversorger und der Erstellung etwaiger Gutschriften, wie oben beschrieben, können nun doppelte Stromzählungen ausgeschlossen werden, indem Lastprofile und zugehörige Schaltzeit eine hohe Ähnlichkeit aufweisen und zur gleichen Schaltzeit nur einmal ausgewertet werden.

Fig. 3 zeigt für die gleiche Sicherheitsmaßnahme wie Fig. 2 eine zusätzliche Steuerung der erfindungsgemäßen Vorrichtung. Die erfindungsgemäße Vorrichtung besteht hierbei zusätzlich aus einem Empfänger und einem Sender, wobei der Sender dafür sorgt, dass auf das Spannungssignal, welches zum nachgeschalteten Verbraucher geführt wird, eine Information aufmoduliert wird, um den Strom zum Verbraucher als bereits gezählt zu "markieren". Der Empfänger liest von der Netzspannung ein solches aufmoduliertes Signal und teilt der erfindungsgemäßen Vorrichtung auf elektronischem Wege mit, dass dieser Strom bereits gezählt ist. Als Folge wird diese erfindungsgemäße Vorrichtung den Schaltvorgang nicht ausführen oder die Zeiten für einen vergünstigten Tarif nicht berechnen.

Da bei Verwendung vieler der oben genannten erfindungsgemäßen Vorrichtungen nach der letztgenannten Methode das Spannungssignal erheblich gestört würde, ist ein optionales Netzfilter in der Vorrichtung vorgesehen, um das aufmodulierte Signal zu filtern und keine Störungen ins allgemeine Stromnetz zurückzuführen.

Eine Markierung des Stromes kann nicht nur durch Modulation von Informationen auf die Spannung des Stromnetzes geschehen, sondern auch aus einer kabelgebundenen Verbindung zwischen zwei erfindungsgemäßen Vorrichtungen oder auch einem Funksignal.

Die vorliegende Erfindung ist nicht auf die Ausführungsbeispiele dieser Beschreibung beschränkt, sondern es sind vielmehr noch weitere Merkmal denkbar. So ist z.B. die Verbindungsmöglichkeit zum Internet nicht nur durch die oben genannten Möglichkeiten realisierbar, sondern auch beispielsweise durch eine Bluetooth-Verbindung, GSM, UMTS etc.

## Patentansprüche

1. Vorrichtung zum Messen von elektrischer Arbeit,
mit mindestens einem schaltbaren Ausgang zum Anschließen mindestens eines elektrischen Verbrauchers an die Vorrichtung,
mit Mitteln zur Verbindungsherstellung der Vorrichtung mit dem Internet,
mit einer Uhr, welche elektronisch von der Vorrichtung zur Ermittlung der aktuellen Uhrzeit genutzt wird,
**dadurch gekennzeichnet,**
**dass** mindestens ein elektronischer Speicher in der Vorrichtung vorgesehen ist, in welchem elektronische Daten gespeichert werden, insbesondere Daten aus dem Internet, Uhrzeiten, Schaltvorgänge sowie die Stromaufnahme der Last
**dass** die Vorrichtung Mittel zur Einbringung einer Smartcard besitzt,
**dass** die intelligente Steuerung des elektronischen Speichers, der Mittel zur Verbindungsherstellung mit dem Internet, des schaltbaren Ausgangs und der Uhr, sowie der Datenspeicherung im elektronischen Speicher durch einen auf der Smartcard integrierten Mikrocontroller geschieht,
und **dass** über die Internetverbindung die Daten aus dem elektronischen Speicher übertragen werden können.

2. Vorrichtung nach Anspruch 1, **dadurch gekennzeichnet, dass** mindestens ein Stecker zum Anschließen der Vorrichtung an einer Steckdose vorgesehen ist.

3. Vorrichtung nach Anspruch 1 oder 2, **dadurch gekennzeichnet, dass** mindestens ein Schalter oder Taster vorgesehen ist, welcher zur Einstellung des Schaltverhaltens des schaltbaren Ausgangs dient.

4. Vorrichtung nach einem der Ansprüche 1 bis 3, **dadurch gekennzeichnet, dass** eine Anzeige und/oder optische und/oder akustische Signalmittel vorgesehen sind.

5. Vorrichtung nach einem der Ansprüche 1 bis 4, **dadurch gekennzeichnet, dass** die Verbindungsmöglichkeit an das Internet aus einem kabelgebundenen Netzwerkanschluss, aus einem WLAN-Anschluss, Mobilfunkanschluss und/oder aus einem Powerline-Anschluss besteht.

6. Vorrichtung nach einem der Ansprüche 1 bis 4, **dadurch gekennzeichnet, dass** die Uhr durch das Zeitsignal der Internetverbindung gestellt wird.

7. Vorrichtung nach einem der Ansprüche 1 bis 6, **dadurch gekennzeichnet, dass** eine Steuermöglichkeit vorgesehen ist, über welche zusätzliche Informationen der Vorrichtung zugeführt werden.

8. Vorrichtung nach Anspruch 7, **dadurch gekennzeichnet, dass** die Steuermöglichkeit über ein auf die Netzspannung aufgebrachtes Signal, über mindestens eine kabelgebundene Steuerleitung und/oder über ein Funksignal realisiert wird.

9. Verfahren zur Messung der elektrischen Arbeit mindestens eines elektrischen Verbrauchers mittels einer Vorrichtung aus einem der Ansprüche 1 bis 8,
wobei die Vorrichtung an eine Steckdose angeschlossen wird,
mindestens ein elektrischer Verbraucher an die Vorrichtung über den schaltbaren Ausgang angeschlossen wird,
die Vorrichtung über die Verbindungsmöglichkeit an das Internet angeschlossen wird,
über diese Internetverbindung vom jeweiligen Stromversorger Informationen zum aktuellen Tarif an die Vorrichtung übermittelt wird,
die Vorrichtung aufgrund der Tarifinformationen über den schaltbaren Ausgang den elektrischen Verbraucher ein- oder ausschaltet,
die Vorrichtung die Tarifinformationen, Uhrzeit, Stromaufnahme und Schaltvorgang im elektronischen Speicher ablegt,
diese Information über die Verbindungsmöglichkeit mit dem Internet oder der Anzeige abrufbar sind
und über die gespeicherten Informationen aus dem elektronischen Speicher der Stromversorger Gutschriften aufgrund des für die jeweilige Vorrichtung verbrauchten Stroms und des verwendeten Tarifs erstellt.

10. Verfahren nach Anspruch 9, **dadurch gekennzeichnet, dass** über den Taster oder Schalter eine definierte Funktion der Vorrichtung eingestellt wird und die Vorrichtung über die Kombination des Tasters oder Schalters mit der Tarifinformation den elektrischen Verbraucher ein- oder ausschaltet.

11. Verfahren nach Anspruch 9 oder 10, **dadurch gekennzeichnet, dass** über die Verbindungsmöglichkeit mit dem Internet feste Tarifinformationen in den elektronischen Speicher der Vorrichtung gespeichert werden
und diese gespeicherten Tarifinformationen dann von der Vorrichtung zum Schalten des schaltbaren Ausgangs verwendet werden.

12. Verfahren nach einem der Ansprüche 9 bis 11, **dadurch gekennzeichnet, dass** die Vorrichtung bei einem Einschaltvorgang eines Verbrauchers ein kurzzeitiges Lastprofil erstellt und in dem elektronischen Speicher ablegt.

13. Verfahren nach Anspruch 12, **dadurch gekennzeichnet, dass** der Stromversorger nur dann Gutschriften in einem Abrechnungszeitraum für einen Verbraucher erstellt, wenn nicht zur gleichen Schaltzeit zwei Geräte mit dem gleichen Lastprofil geschaltet wurden.

14. Verfahren nach einem der Ansprüche 9 bis 11, **dadurch gekennzeichnet, dass** die Vorrichtung über die Steuermöglichkeit den geschalteten Strom kennzeichnet
und der Vorrichtung nachgeschaltete zusätzliche Vorrichtungen den gekennzeichneten Strom nicht nochmals schalten und/oder zählen.

15. Verfahren nach einem der Ansprüche 9 bis 14, **dadurch gekennzeichnet, dass** ein Mikrocontroller, welcher in die Vorrichtung oder auf der Smartcard integriert ist, die Steuerung der Vorrichtung, sowie die Schaltvorgänge übernimmt.

16. Verfahren nach einem der Ansprüche 9 bis 15, **dadurch gekennzeichnet, dass** über die Verbindungsmöglichkeit Daten von weiteren elektrischen Zählern in den elektronischen Speicher eingelesen und/oder übertragen werden.

## Claims

1. Device for measuring electrical work,
with at least one switchable output for connecting at least one electrical load to the device,
with means for establishing an Internet connection for the device,
with a clock which is used electronically by the device for determining the current time,
thereby **characterized**
**in that** included in the device is at least one electronic memory in which electronic data is to be stored, in particular, data from the Internet, times, switching procedures and likewise the current consumption of the load,
**in that** the device has a means for insertion of a smartcard,
**in that** the intelligent control of the electronic memory, the means of connection to the Internet, the switchable output and the clock, as well as data storage in the electronic memory, is done by means of a microcontroller integrated onto the smartcard,
and **in that** the data from the electronic memory can be transmitted over the Internet connection.

2. Device pursuant to Claim 1, thereby **characterized in that** at least one plug is provided for connecting the device to a socket.

3. Device pursuant to Claim 1 or 2, thereby **characterized in that** provided is at least one switch or key button for setting the switch behavior of the switchable output.

4. Device pursuant to one of the claims 1 to 3, thereby **characterized in that** a display and/or optical and/or acoustic alarm device are provided.

5. Device pursuant to one of the claims 1 to 4, thereby **characterized in that** the possibilities of connecting to the Internet comprise a wired network connection, a WLAN connection, a mobile phone connection and/or a power line connection.

6. Device pursuant to one of the claims 1 to 4, thereby **characterized in that** the clock is set by means of the Internet connection time signal.

7. Device pursuant to one of the claims 1 to 6, thereby **characterized in that** a control possibility is provided by means of which additional information is fed to the device.

8. Device pursuant to Claim 7, thereby **characterized in that** the control possibility is achieved by means of a signal applied to the mains voltage, by means of a wired control line and/or by means of a radio signal.

9. Process for measuring the electrical work of at least one electrical load by means of a device from one of the claims 1 to 8,
whereby the device is connected to a socket,
at least one electrical load is connected to the device by means of the switchable output,
the device is connected to the Internet by means of the connection possibility,
by means of this Internet connection, information from the pertinent electricity supplier as to the current rate is transmitted to the device,
based on the rate information, the device switches the electrical load on or off by means of the switchable output,
the device stores the rate information, time, current consumption and switching operation in the electronic memory,
this information is retrievable by means of the connection possibility with the Internet or the display,
and by means of the stored information from the electronic memory, the electricity supplier prepares vouchers based on the power consumed by the respective device and the relevant rate.

10. Process pursuant to Claim 9, thereby **characterized in that** by means of the key button or switch a defined function of the device will be set, and by means of the combination of key button or switch with the rate information the device will switch the electrical load on or off.

11. Process pursuant to Claim 9 or 10, thereby **characterized in that** by means of the connection possibility with the Internet, fixed rate information will be stored in the electronic memory of the device,
and this stored rate information will then be used by the device to switch the switchable output.

12. Process pursuant to one of the claims 9 to 11, thereby **characterized in that** the device, in the event of a switch-on operating sequence by a user, will generate a temporary load profile and store it in the electronic memory.

13. Process pursuant to Claim 12, thereby **characterized in that** the electricity supplier prepares vouchers in a billing period for a user only if in the same circuit time no two devices with the same load profile have been connected.

14. Process pursuant to one of the claims 9 to 11, thereby **characterized in that** the device identifies the connected current by means of the control possibility,
and additional devices downstream of the device do not again connect and/or count the identified current.

15. Process pursuant to one of the claims 9 to 14, thereby **characterized in that** a microcontroller which is integrated into the device or onto the smartcard assumes control of the device as well as the switching operations.

16. Process pursuant to one of the claims 9 to 15, thereby **characterized in that** by way of the connection possibility, data from further electrical counters are read into and/or transmitted to the electronic memory.

## Revendications

1. Dispositif destiné à mesurer du travail électrique,
comprenant au moins une sortie commutable servant à raccorder au moins un consommateur électrique au dispositif,
comprenant des moyens pour établir la liaison entre le dispositif et Internet,
comprenant une horloge utilisée électroniquement par le dispositif pour déterminer l'heure actuelle,
**caractérisé en ce que**
au moins une mémoire électronique a été prévue dans le dispositif, mémoire dans laquelle les données électroniques sont enregistrées, en particulier des données provenant d'Internet, des horaires, des séquences de commutation ainsi que l'intensité absorbée par la charge,
le dispositif présente des moyens pour insérer une carte intelligente,
le pilotage intelligent de la mémoire électronique, des moyens servant à établir la liaison avec Internet, de la sortie commutable et de l'horloge, ainsi que de l'enregistrement des données dans la mémoire électronique est assuré par un microcontrôleur intégré dans la carte intelligente,
et **en ce que** les données peuvent, via la liaison par Internet, être transmises depuis la mémoire électronique.

2. Dispositif selon la revendication 1, **caractérisé en ce qu'**au moins un connecteur est prévu pour raccorder le dispositif à une prise.

3. Dispositif selon la revendication 1 ou 2, **caractérisé en ce qu'**au moins un commutateur ou une touche est prévu(e) pour régler le comportement en commutation de la sortie commutable.

4. Dispositif selon l'une des revendications 1 à 3, **caractérisé en ce qu'**un afficheur et/ou des moyens de signalisation optique et/ou acoustique ont été prévus.

5. Dispositif selon l'une des revendications 1 à 4, **caractérisé en ce que** la possibilité de raccordement à Internet se compose d'un raccordement câblé à un réseau, d'un raccordement à un réseau WLAN sans câble, d'un raccordement à un réseau de téléphonie mobile et/ou d'un raccordement Powerline.

6. Dispositif selon l'une des revendications 1 à 4, **caractérisé en ce que** le réglage de l'horloge a lieu par le signal à cet effet arrivant via la liaison Internet.

7. Dispositif selon l'une des revendications 1 à 6, **caractérisé en ce qu'**un moyen de pilotage a été prévu via lequel des informations supplémentaires parviennent au dispositif.

8. Dispositif selon la revendication 7, **caractérisé en ce que** le moyen de pilotage est réalisé via un signal ajouté à la tension du secteur, via au moins une ligne pilote câblée et/ou via un signal radio.

9. Dispositif servant à mesurer le travail électrique d'au moins un consommateur électrique au moyen d'un dispositif selon l'une des revendications 1 à 8,
sachant que le dispositif se raccorde à une prise,
qu'au moins un consommateur électrique se raccorde au dispositif via la sortie commutable,
que le dispositif se raccorde à Internet via la possibilité de liaison.
que via cette liaison Internet, le distributeur d'électricité respectif transmet au dispositif des informations sur le tarif actuel,
que le dispositif, via la sortie commutable, allume ou éteint le consommateur électrique en fonction des informations tarifaires,
que le dispositif enregistre les informations tarifaires, l'heure, l'intensité absorbée et la séquence de commutation dans la mémoire électronique,
que cette information peut être sollicitée via le moyen de liaison avec Internet ou via l'afficheur,
et que via les informations enregistrées provenant de la mémoire électronique, le distributeur d'électricité peut établir des avoirs en fonction de l'électricité consommée pour le dispositif respectif, et en fonction du tarif appliqué.

10. Procédé selon la revendication 9, **caractérisé en ce que** le réglage d'une fonction définie du dispositif a lieu via une touche ou un commutateur
et que le dispositif allume ou éteint le consommateur électrique via une combinaison de la touche ou du commutateur avec l'information tarifaire.

11. Procédé selon la revendication 9 ou 10, **caractérisé en ce que** via la possibilité de liaison avec Internet, des informations tarifaires fixes sont enregistrées dans la mémoire électronique du dispositif
et que ces informations tarifaires enregistrée sont ensuite utilisées par le dispositif pour commuter la sortie commutable.

12. Procédé selon les revendications 9 à 11, **caractérisé en ce que** le dispositif établit un profil de charge de courte durée lors de la séquence d'enclenchement d'un consommateur, et dépose ce profil dans la mémoire électronique.

13. Procédé selon la revendication 12, **caractérisé en ce que** le distributeur d'électricité n'établit d'avoirs couvrant sur la période de décompte visant un consommateur qu'à la condition que deux appareils présentant le même profil de charge n'aient pas été commutés au même moment.

14. Procédé selon l'une des revendications 9 à 11, **caractérisé en ce que** le dispositif marque l'électricité commutée via le moyen de pilotage
et **en ce que** des dispositifs d'appoint situés en aval du dispositif ne commutent et/ou ne comptent pas encore une fois l'électricité marquée.

15. Procédé selon l'une des revendications 9 à 14, **caractérisé en ce qu'**un microcontrôleur intégré dans le dispositif ou sur la carte intelligente prend en charge le pilotage du dispositif ainsi que les séquences de commutation.

16. Procédé selon l'une des revendications 9 à 15, **caractérisé en ce que** via la possibilité de liaison, des données provenant d'autres compteurs électriques sont enregistrées et/ou transmises dans la mémoire électronique.
